# EUROPEAN PATENT APPLICATION

(11) **EP 2 706 651 A2**
(43) Date of publication of application: **12.03.2014**
(21) Application number: 13181861.9
(22) Date of filing: 27.08.2013
(51) Int. Cl.: H02M 3/158, H01L 27/06

(54) **Integrated power stage with group III-V transistors**

(30) Priority: 07.09.2012 US 201261698499 P; 08.10.2012 US 201261710859 P; 26.08.2013 US 201313975695
(71) Applicant: International Rectifier Corporation, El Segundo, CA 90245 (US)
(72) Inventor: Briere, Michael A., Scottsdale, AZ Arizona 85266 (US); McDonald, Tim, Redondo Beach, AZ Arizona 90277 (US)
(74) Representative: Dr. Weitzel & Partner

(57) **Abstract**

In one implementation, an integrated group III-V power stage (100) includes a control switch (108) including a first group III-V transistor coupled to a sync switch (106) including a second group III-V transistor. The integrated group III-V power stage may also include one or more driver stages (104), which may be fabricated in a group III-V die or dies. The driver stage or driver stages, the control switch, and the sync switch may all be situated in a single semiconductor package (101).

## Description

### BACKGROUND

The present application claims the benefit of and priority to pending provisional application entitled "Integrated III-N Synchronous Boost Converter," Serial No. 61/698,499 filed on September 7, 2012. The present application also claims the benefit of and priority to pending provisional application entitled "Integrated III-N Synchronous Boost Converter," Serial No. 61/710,859 filed on October 8, 2012. The disclosures in these pending provisional applications are hereby incorporated fully by reference into the present application.

### I. DEFINITIONS

As used herein, the phrase "group III-V" refers to a compound semiconductor including at least one group III element and at least one group V element. By way of example, a group III-V semiconductor may take the form of a III-Nitride semiconductor. "III-Nitride", or "III-N", refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar, or non-polar crystal orientations. A III-Nitride material may also include either the Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium. A group III-V or a GaN transistor may also refer to a composite high voltage enhancement mode transistor that is formed by connecting the group III-V or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

It is noted that, as used herein, the terms "low voltage" or "LV" in reference to a transistor or switch corresponds describes a transistor or switch with a voltage range of up to approximately fifty volts (50V). It is further noted that use of the term "midvoltage" or "MV" refers to a voltage range from approximately fifty volts to approximately three hundred volts (approximately 50V-300V). Moreover, the term "high voltage" or "HV", as used herein, refers to a voltage range from approximately three hundred volts to approximately twelve hundred volts (approximately 300V-1200V), or higher.

### II. BACKGROUND ART

Power converters are used in a variety of electronic circuits and systems. Many lighting and automotive applications, for instance, require conversion of a direct current (DC) voltage to a different DC voltage. A power converter is typically comprised of a power stage (including power switches and a driver stage), control circuitry, and at least one energy storage element or load, such as an inductor, capacitor, or a combination of the two. For example, a boost converter may be utilized as a voltage regulator to convert a lower voltage DC input to a higher voltage DC output.

The switches in a basic boost converter power stage typically include a diode and a transistor. In the conventional art, a basic boost converter may be implemented using silicon diode and a silicon transistor. However, silicon diodes may exhibit undesirably large reverse recovery losses. In addition, silicon diodes typically exhibit a forward voltage drop of approximately one to approximately one and a half volts (approximately 1.0V-1.5V). Moreover, expensive silicon carbide (SiC) based Schottky diodes, although capable of fast switching, typically exhibit a forward voltage drop of approximately one and a half volts to approximately two and a half volts (approximately 1.5V-2.5V). As a result, these conventional implementations may result in conversion losses that render the performance of silicon based converters more noisy, less efficient, and/or more expensive than is desirable.

If higher efficiency is desired, a modified converter and power stage design known as synchronous boost can be used in which the diode is replaced by a second transistor. A synchronous boost converter typically utilizes power transistors selected for low losses as control and synchronous (sync) power switches, which helps to improve the converter efficiency. The synchronous power stage then includes additional elements including gate drivers for the power transistors.

### SUMMARY

The present disclosure is directed to an integrated group III-V power stage, substantially as shown in and/or described in connection with at least one of the figures, and as set forth more completely in the claims.

### BRIEF DESCRIPTION OF THE DRAWINGS

Figure 1 shows a plan view of a semiconductor package including an integrated group III-V synchronous boost converter, according to one exemplary implementation.
Figure 2 shows a plan view of a semiconductor package including an integrated group III-V synchronous boost converter, according to another exemplary implementation.
Figure 3A shows a plan view of a semiconductor package including an integrated group III-V synchronous boost converter having a composite power switch, according to one exemplary implementation.
Figure 3B shows a plan view of a semiconductor package including an integrated group III-V synchronous boost converter having a composite power switch, according to another exemplary implementation.
Figure 3C shows a plan view of a semiconductor package including an integrated group III-V synchronous boost converter having two composite power switches, according to one exemplary implementation.
Figure 4 shows a plan view of a semiconductor package including a power stage for an integrated group III-V synchronous boost converter, according to one exemplary implementation.
Figure 5 shows a plan view of a semiconductor package including an integrated group III-V synchronous boost converter, according to yet another exemplary implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As stated above, synchronous boost converters typically utilize power transistors as control and synchronous (sync) power switches, and include drivers for those power switches. As also stated above, in the conventional art, a synchronous boost converter may be implemented using silicon transistors for the control and sync switches. However, silicon based synchronous boost converters may be susceptible to excessive switching losses. Switching losses may take several forms. For example, switching losses may include losses resulting from current/voltage overlap during the switching transition, as well as to charging and discharging of switch capacitances. Switching losses may also include reverse recovery loss due to negative current flow through the body diode of a silicon based metal-oxide-semiconductor field-effect transistor (MOSFET), for example, when the body diode is taken from forward to reverse bias. As a result, conventional silicon based synchronous boost converters may produce switching losses that render the performance of those silicon based synchronous boost converters less efficient than is desirable.

The present application discloses an integrated group III-V synchronous boost converter utilizing group III-V drive circuitry and/or control and sync switches including group III-V power transistors. The group III-V transistors and drive circuitry may be integrated in various ways, and may be situated in a single semiconductor package. By utilizing control and sync switches including group III-V transistors, such as III-Nitride based transistors for example, the switching losses of the control and sync switches can be reduced relative to conventional silicon based implementations. As a result, use of III-Nitride or other group III-V semiconductor based transistors to implement a higher voltage (i.e., approximately 175V-1300V, or higher) synchronous boost converter can advantageously reduce switching losses and improve operating efficiency.

It is noted that in the interests of ease and conciseness of description, the present inventive principles will in some instances be described by reference to specific implementations including one or more gallium nitride (GaN) based transistors. However, it is emphasized that such an implementations are merely exemplary, and the inventive principles disclosed herein are broadly applicable to a wide range of applications implemented using other III-Nitride material based, or other group III-V semiconductor based, transistors.

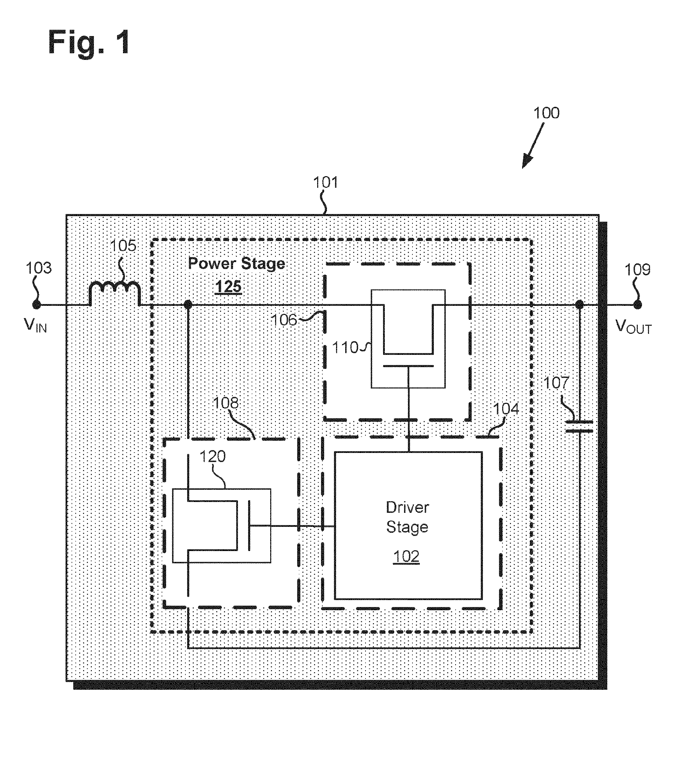

Figure 1 shows a plan view of integrated group III-V synchronous boost converter 100, according to one exemplary implementation. Boost converter 100 includes power stage 125, which in turn includes control switch 120, sync switch 110, and driver stage 102. Driver stage 102 is fabricated in die 104, while control switch 120 is fabricated in group III-V die 108 and sync switch 110 is fabricated in group III-V die 106. Boost converter 100 also includes input inductor 105 and output capacitor 107, both of which are coupled to power stage 125. Also shown in Figure 1 is semiconductor package 101.

As shown in Figure 1, boost converter 100 can receive an input voltage V_{IN} at input 103 of boost converter 100, and provide a converted voltage, e.g., a higher "stepped up" voltage V_{OUT}, at output 109 of boost converter 100. In some implementations, not shown by Figure 1, boost converter 100 may also include a controller or other converter elements including DC enable switches, PWM circuitry, level shift circuitry, temperature sensors and controllers, modulators, comparators, amplifiers, and logic and protection circuitry, for example.

According to the exemplary implementation shown in Figure 1, die 104 providing driver stage 102, group III-V die 108 providing control switch 120, and group III-V die 106 proving sync switch 110 are situated in semiconductor package 101. Thus, according to the present exemplary implementation, semiconductor package 101 may take the form of a multi-chip module (MCM) configured to contain three dies, i.e., die 104 and group III-V dies 106 and 108. In addition, and as further shown by Figure 1, in some implementations, input inductor 105 and output capacitor 107 may also be situated in semiconductor package 101. It is further noted that the plan view shown by Figure 1 is presented in the interests of conceptual clarity so as to show input inductor 105, driver stage 102, control switch 120, sync switch 110, and output capacitor 107 as though seen through the enclosure provided by semiconductor package 101.

Die 104 may be implemented as a silicon or other group IV die. However, in some implementations, it may advantageous or desirable to implement die 104 as a group III-V die, such as a III-Nitride die. In those latter implementations, die 104 may be formed so as to have one or more layers including GaN, for example. As shown in Figure 1, driver stage 102 may be fabricated in die 104. As a result, driver stage 102 may be implemented using group IV or group III-V based circuitry. For example, in one implementation driver stage 102 may include III-Nitride or other group III-V driver and/or predriver transistors for driving control switch 120 and sync switch 110 (driver/predriver transistors not explicitly shown in Figure 1).

Although also not explicitly shown in Figure 1, driver stage 102 typically includes additional elements, such as level shift circuitry and logic and protection circuitry, and may also include pulse-width modulation (PWM) circuitry, any of which may be monolithically integrated in die 104. According to the present implementation, driver stage 102 in die 104 drives control switch 120 in die 108 and sync switch 110 in die 106. Thus control switch 120 and sync switch 110 may be discrete switches. In another implementation, synchronous boost converter 100 may be configured with inrush current protection and short circuit protection as disclosed in U.S. Patent Number RE41,766, entitled "Self-Driven Synchronous Rectified Boost Converter with Inrush Current Protection Using Bidirectional Normally-On-Device", and issued on September 28, 2010. This patent is hereby incorporated fully by reference into the present application. Thus, for example, one or both of control switch 120 and sync switch 110 may be a bi-directional dual gated III-Nitride or other group III-V transistor.

Control switch 120 and sync switch 110 are fabricated in Group III-V dies 108 and 106, respectively, which may be formed as III-Nitride dies including one or more GaN based layers, for example. In one implementation, group III-V dies 106 and 108 may include a group III-V active die formed over a group IV substrate, such as a silicon substrate. Thus, in addition to one or more III-Nitride or other group III-V layers, group III-V dies 106 and 108 may also include one or more silicon or other group IV layers.

Alternatively, control switch 120 and sync switch 110 may be monolithically integrated in a common group III-V die (not shown in Figure 1), in which case some features used to integrate control switch 120 and sync switch 110 may be formed within a group IV substrate or group IV device layer included in the common group III-V die. In some implementations, driver stage 102 as well as control switch 120 and sync switch 110 may adopt a monolithic configuration as disclosed by U.S. Patent Number 7,863,877, entitled "Monolithically Integrated III-Nitride Power Converter", and issued on January 4, 2011. The above-referenced patent is hereby incorporated fully by reference into the present application.

Control switch 120 and sync switch 110 each include at least one group III-V transistor, and may be implemented as group III-V heterostructure FETs (HFETs), such as III-Nitride high electron mobility transistors (HEMTs) for example. Control switch 120 and sync switch 110 may be depletion mode (normally ON) or enhancement mode (normally OFF) transistors. In some implementations, one of control switch 120 and sync switch 110 may be implemented as an enhancement mode transistor while the other of control switch 120 and sync switch 110 is implemented as a depletion mode transistor. In some implementations, as will be described in greater detail below, one or both of control switch 120 and sync switch 110 may take the form of composite switches including a group III-V transistor and a group IV transistor in cascode. Moreover, in some implementations, control switch 120 and sync switch 110 may be configured as a half-bridge, as disclosed by U.S. Patent Number 8,243,476, entitled "HEMT/GaN Half-Bridge Circuit", and issued on August 14, 2012; and U.S. Patent Application Number 12/234,829, entitled "Individually Controlled Multiple III-Nitride Half Bridges" filed on September 22, 2008. The above-referenced patent and patent application are hereby incorporated fully by reference into the present application.

Semiconductor package 101 may be implemented utilizing a quad-flat no-leads (QFN) package design, for example. Semiconductor package 101 may be a lead frame package, or may be formed on a package substrate using a laminate technology, as known in the art. Thus, in some implementations, semiconductor package 101 may be a laminate package. Die 104 providing driver stage 102 and group III-V dies 106 and 108 providing switches 110 and 120, respectively, may be mounted face up and wirebonded, ribbon bonded or copper (Cu) clipped, or may be flip-chip mounted to a package substrate or lead frame of semiconductor package 101.

In some implementations, power switches 110 and 120 and driver stage 102 may be configured so as to make electrical connection with one another, for example as shown in Figure 1, through the package substrate or lead frame of semiconductor package 101. As used herein, the term "package substrate" refers to a structural base of the package to which the various microelectronic components comprising the packaged semiconductor device are typically mounted or attached. The package substrate may be conductive or nonconductive. The package substrate may be metal, plastic, laminate, ceramic, ceramic base such as direct bonded copper (DBC) or a printed circuit board (PCB) for example. In some cases the package substrate could be an interposer as commonly used in grid array assemblies such as ball grid array (BGA), land grid array (LGA) amongst others.

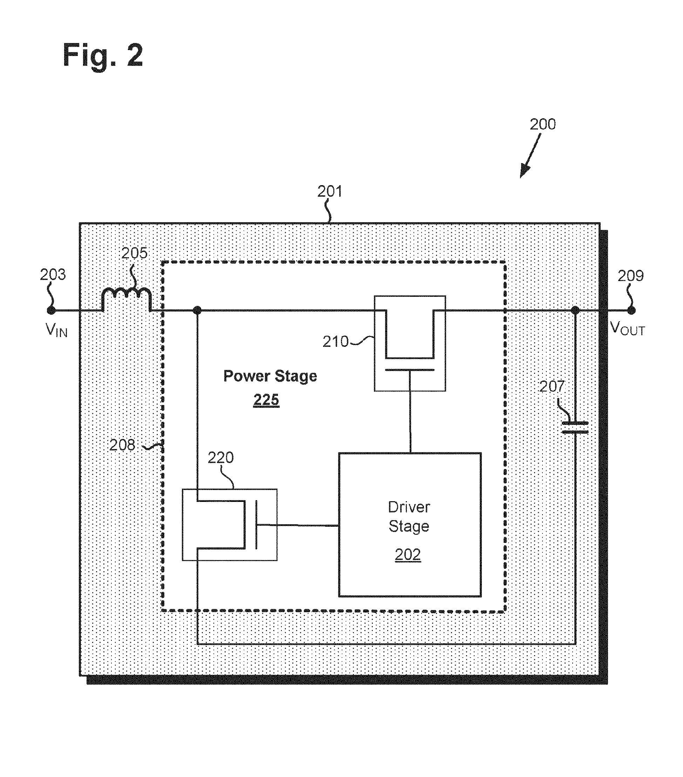

Moving to Figure 2, Figure 2 shows a plan view of semiconductor package 201 including integrated group III-V synchronous boost converter 200, according to another exemplary implementation. Boost converter 200 includes power stage 225, which further includes driver stage 202, and control switch 220 coupled to sync switch 210. Power stage 225 including control switch 220, sync switch 210, and driver stage 202 is fabricated in common group III-V die 208. That is to say, control switch 220, sync switch 210, and driver stage 202 are fabricated in a single semiconductor die. Boost converter 200 also includes input inductor 205 and output capacitor 207, both of which are coupled to power stage 225. As shown in Figure 2, boost converter 200 can receive an input voltage V_{IN} at input 203 of boost converter 200, and provide a converted voltage, e.g., a higher "stepped up" voltage V_{OUT}, at output 209 of boost converter 200.

According to the exemplary implementation shown in Figure 2, group III-V die 208 providing power stage 225 including driver stage 202, control switch 220, and sync switch 210 is situated in semiconductor package 201. Thus, according to the present exemplary implementation, semiconductor package 201 may be configured to contain a single semiconductor die, i.e., group III-V die 208. In addition, and as further shown by Figure 2, in some implementations, semiconductor package 201 also has input inductor 205 and output capacitor 207 situated therein. It is further noted that the plan view shown by Figure 2 is presented in the interests of conceptual clarity so as to show input inductor 205, driver stage 202, control switch 220, sync switch 210, and output capacitor 207 as though seen through the enclosure provided by semiconductor package 201.

Input inductor 205, output capacitor 207, and power stage 225 including driver stage 202, control switch 220, and sync switch 210 correspond respectively to input inductor 105, output capacitor 107, and power stage 125 including driver stage 102, control switch 120, and sync switch 110, in Figure 1, and may share any of the characteristics attributed to those corresponding features, above. As shown in Figure 2, according to the present implementation, driver stage 202 may be fabricated in group III-V die 208. As a result, driver stage 202 may be implemented using group III-V circuitry, such as III-Nitride or other group III-V driver and/or predriver transistors (driver transistors also referred to herein as "gate drives") for driving control switch 120 and sync switch 110 (driver/predriver transistors not explicitly shown in Figure 2). Thus, in some implementations, at least one gate drive of driver stage 202 is integrated with at least one of control switch 220 and sync switch 210.

Although also not explicitly shown in Figure 2, driver stage 202 typically includes additional elements, such as level shift circuitry and logic and protection circuitry, and may also include PWM circuitry, any of which may be monolithically integrated in group III-V die 208. As shown in Figure 2, according to the present implementation, driver stage 202 is configured to drive both control switch 220 and sync switch 210 of power stage 225.

Group III-V die 208 may be formed as a III-Nitride die including one or more GaN based layers, for example. In one implementation, group III-V die 208 may include a group III-V active die formed over a group IV substrate, such as a silicon substrate. Thus, in addition to one or more III-Nitride or other group III-V layers, group III-V die 208 may also include one or more silicon or other group IV layers. Several examples of forming group III-Nitride layers over a silicon substrate using compositionally graded III-Nitride transistion layers and amorphous strain absorbing layers are disclosed in U.S. Patent Number 6,649,287, entitled "Gallium Nitride Materials and Methods" issued on November 18, 2003; and U.S. Patent Number 7,339,205, titled "Gallium Nitride Materials and Methods Associated with the Same", issued on March 4, 2008. The above-referenced patents are hereby incorporated fully by reference into the present application.

Thus, one or both of control switch 120 and sync switch 110 may be formed over a compositionally graded III-Nitride layer and/or an amorphous strain absorbing layer. Moreover, in certain implementations where the III-Nitride layers are formed over a silicon substrate, other elements of the power converter and associated circuit may be monolithically formed in the silicon substrate.

Semiconductor package 201 may be implemented utilizing a QFN package design, for example. Semiconductor package 201 may be a lead frame package, or may be formed on a package substrate using a laminate technology, as known in the art. Group III-V die 208 providing power stage 225 may be mounted face up and wirebonded, ribbon bonded or Cu clipped, or may be flip-chip mounted to a package substrate or lead frame of semiconductor package 201.

As noted above, control switch 120/220 and/or sync switch 110/210 in respective Figures 1 and 2 may be implemented as III-Nitride or other group III-V HEMTs. Group III-V HEMTs, such as GaN or other III-Nitride material based HEMTs, typically operate using piezoelectric polarization fields to generate a two-dimensional electron gas (2DEG) allowing for high current densities with low resistive losses. Because the 2DEG can arise naturally at a heterojunction interface of the III-Nitride or other group III-V materials forming the HEMTs, group III-V HEMTs typically conduct without the application of a gate potential. That is to say, III-Nitride and other group III-V HEMTs tend to be depletion mode (i.e., normally ON) transistors.

However, the normally ON nature of group III-V HEMTs can give rise to problems when such depletion mode transistors are used as power switches. For example, in power applications it is typically desirable to avoid conducting current through the group III-V HEMTs before control circuitry is fully powered and operational. As a result, in power management applications where enhancement mode (i.e., normally OFF) characteristics of power switches are desirable, a depletion mode III-Nitride or other group III-V transistor can be cascoded with a silicon or other group IV enhancement mode transistor, to produce a normally OFF composite switch.

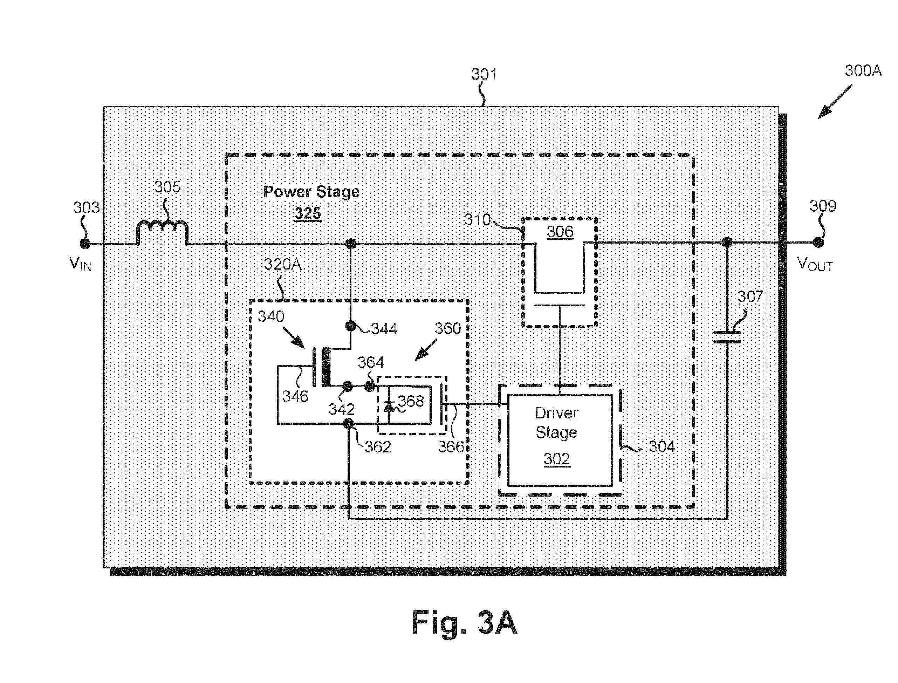

Referring to Figure 3A, Figure 3A shows a plan view of semiconductor package 301 including integrated group III-V synchronous boost converter 300A having a composite power switch, according to one exemplary implementation. Boost converter 300A includes power stage 325, which further includes driver stage 302 in die 304, and composite control switch 320A coupled to sync switch 310. Boost converter 300A also includes input inductor 305 and output capacitor 307, both of which are coupled to power stage 325. As shown in Figure 3A, boost converter 300A can receive an input voltage V_{IN} at input 303 of boost converter 300A, and provide a converted voltage, e.g., a higher "stepped up" voltage V_{OUT}, at output 309 of boost converter 300A.

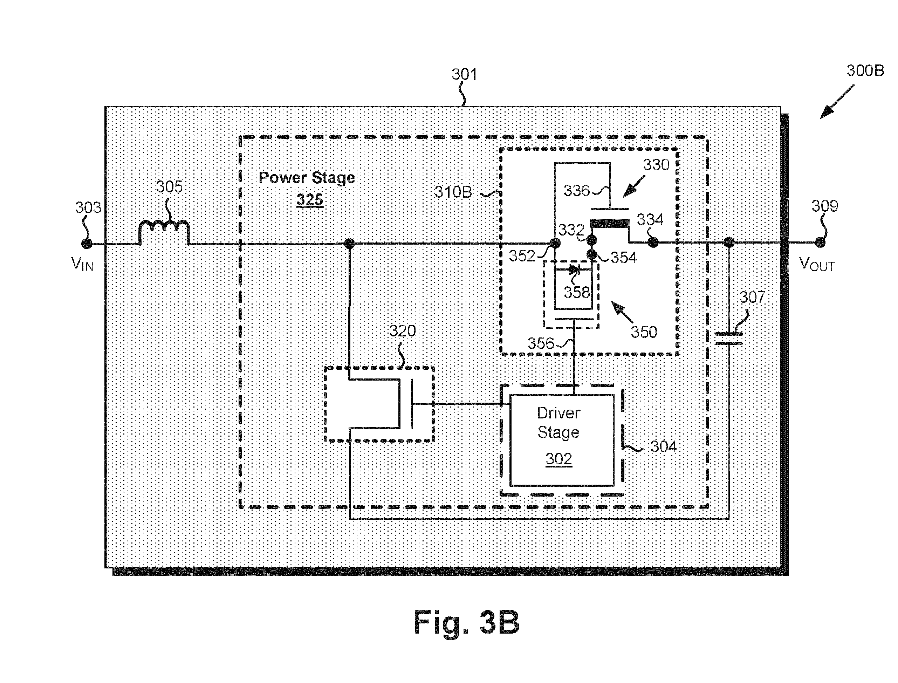

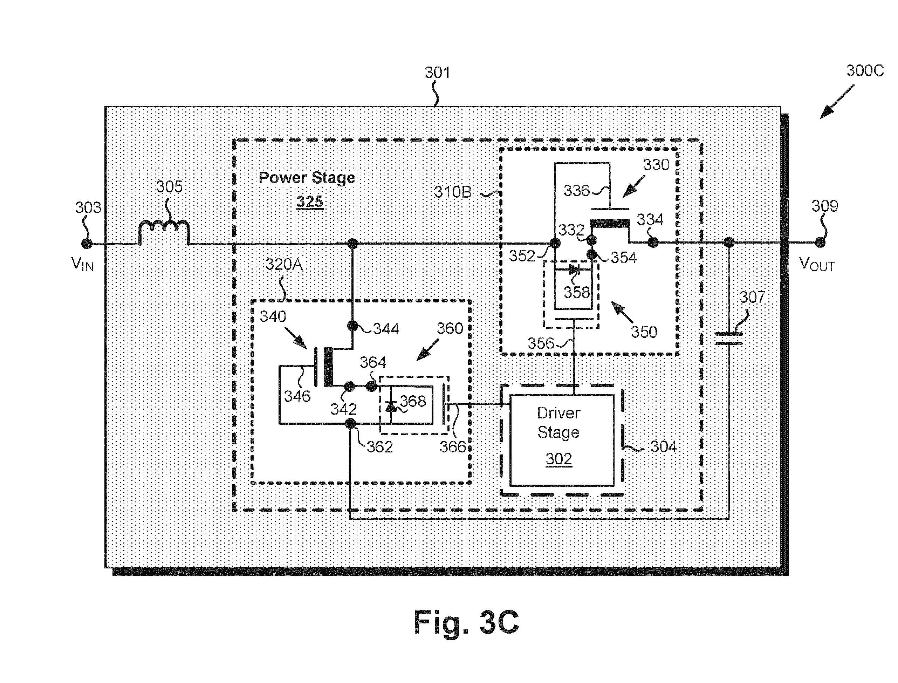

According to the exemplary implementation shown in Figure 3A, power stage 325 is situated in semiconductor package 301. In addition and as further shown by Figure 3, in some implementations, semiconductor package 301 may also have input inductor 305 and output capacitor 307 situated therein. Semiconductor package 301, input inductor 305, output capacitor 307, die 304, and driver stage 302, correspond respectively to semiconductor package 101, input inductor 105, output capacitor 107, die 104, and driver stage 102, in Figure 1, and may share any of the characteristics attributed to those corresponding features, above. In addition, sync switch 310 and die 306, in Figure 3, corresponds to sync switch 110 and die 106, respectively, in Figure 1, and may share any of the characteristics attributed to that corresponding feature, above.

In some implementations, one, or both of the power stage control switch and sync switch may be implemented as a composite switch. Furthermore, one or both of the power stage control switch and sync switch may be implemented as depletion mode, enhancement mode, bi-directional, dual gated, or cascode composite switches. According to the implementation shown in Figure 3A, for example, power stage 325 includes composite control switch 320A. As shown in Figure 3A, composite control switch 320A includes group III-V transistor 340 and group IV transistor 360.

Group III-V transistor 340 may be a GaN or other III-Nitride based depletion mode HEMT. Group III-V transistor 340 includes source 342, drain 344, and gate 346. Group IV transistor 360 may be implemented as a low voltage (LV) group IV transistor, such as an LV silicon based MOSFET, for example. Group IV transistor 360 includes source 362, drain 364, and gate 366. Also shown in Figure 3A is an optional body diode 368 of group IV transistor 360.

As shown in Figure 3A, group III-V transistor 340 is cascoded with group IV transistor 360 to produce composite control switch 320A. That is to say, source 342 of group III-V transistor 340 is coupled to drain 364 of group IV transistor 360, source 362 of group IV transistor 360 provides a composite source for composite control switch 320A, and gate 366 of group IV transistor 360 provides a composite gate for composite control switch 320A. Moreover, drain 344 of group III-V transistor 340 provides a composite drain for composite control switch 320A, while gate 346 of group III-V transistor 340 is coupled to source 362 of group IV transistor 360.

In some implementations, composite control switch 320A may adopt a cascoded configuration as disclosed by U.S. Patent Number 8,017,978, entitled "Hybrid Semiconductor Device", and issued on September 13, 2011; U.S. Patent Number 8,084,783, entitled "GaN-based Device Cascoded with an Integrated FET/Schottky Diode Device", and issued on December 27, 2011; U.S. Patent Application Number 13/415,779, entitled "Composite Semiconductor Device with Turn-On Prevention Control", and filed on March 8, 2012; U.S. Patent Application Number 13/416,252, entitled "High Voltage Composite Semiconductor Device with Protection for Low Voltage Device", and filed on March 9, 2012; and U.S. Patent Application Number 13/417,143, entitled "Composite Semiconductor Device with Active Oscillation Prevention", and filed on March 9, 2012. The above-referenced patents and patent applications are hereby incorporated fully by reference into the present application.

In yet other implementations, group IV transistor 360 may be an n-channel transistor, a p-channel transistor, a lateral FET, or a vertical FET. In some implementations (not shown), group IV transistor 360 may be replaced with an enhancement mode group III-V or III-Nitride FET.

The operation of composite control switch 320A as a normally OFF switch through use of group IV transistor 360 is now briefly described. When voltage is applied to drain 344 of depletion mode group III-V transistor 340 and while the gate voltage to group IV transistor 360 is less than the threshold voltage of group III-V transistor 360 (i.e., group IV transistor 360 is OFF) voltage will develop across reverse biased body diode 368 of group IV transistor 360. This voltage is inverted and applied to gate 346 of depletion mode group III-V transistor 340. As the applied voltage to gate 346 of group III-V transistor 340 increases below the (negative) pinch-off voltage for group III-V transistor 340, group III-V transistor 340 will turn OFF. Assuming that group IV transistor 360 and depletion mode group III-V transistor 340 are suitably selected such that group IV transistor 360 including body diode 368 can block a voltage in excess of a pinch-off voltage of depletion mode group III-V transistor 340, depletion mode group III-V transistor 340 will turn OFF and any additional increase in voltage at drain 344 will be sustained across group III-V transistor 340.

When the voltage applied to gate 366 of group IV transistor 360 is greater than the threshold voltage of group IV transistor 360, the voltage applied to gate 366 of transistor 360 is much lower in magnitude than the pinch off voltage of group III-V transistor 340 and both the group IV and group III-V transistors have low resistance, resulting in the composite control switch 320A being in the On-state. Consequently, composite control switch 320A operates as an enhancement mode (normally OFF) switch that can be selectively turned ON or OFF based on a gate voltage applied by driver stage 302 to gate 366 of group IV transistor 360.

In some implementations, depletion mode group III-V transistor 340 and group IV transistor 360 of composite control switch 320A may be fabricated in separate semiconductor dies (separate semiconductor dies not shown in Figure 3A). For example, group III-V transistor 340 may be fabricated in a group III-V die, which may include a group III-V active die formed over a group IV substrate, while group IV transistor 360 may be fabricated in a separate group IV die. In those implementations, it may be advantageous or desirable to mount the group III-V die providing group III-V transistor 340 on or over the group IV die providing group IV transistor 360. Examples of such die mounting configurations are disclosed in U.S. Patent Application Number 13/433,864 entitled "Stacked Composite Device Including a Group III-V Transistor and a Group IV Lateral Transistor", filed on March 29, 2012; and U.S. Patent Application Number 13/434,412 entitled "Stacked Composite Device Including a Group III-V Transistor and a Group IV Vertical Transistor", also filed on March 29, 2012. These patent applications are hereby incorporated fully by reference into the present application.

Alternatively, in some implementations, it may be advantageous or desirable to mount the group IV die providing group IV transistor 360 on or over the group III-V die providing group III-V transistor 340. Thus, in some implementations, group III-V transistor 340 and group IV transistor 360 may be die-stacked integrated.

Moreover, in one implementation, group III-V transistor 340 may be integrated with sync switch 310 on a common group III-V die separate from a group IV die used for fabrication of group IV transistor 360. Examples of such die mounting configurations are disclosed in U.S. Patent Application Number 13/053,556, entitled "III-Nitride Transistor Stacked with FET in a Package", filed on March 22, 2011. This patent application is hereby incorporated fully by reference into the present application.

The die or dies used to implement power stage 325 may be mounted face up and wirebonded, ribbon bonded or Cu clipped, or may be flip-chip mounted to a package substrate or lead frame of semiconductor package 301. In some implementations, the die or dies used to implement power stage 325, including die 304 providing driver stage 302, may be configured so as to make electrical connection with one another through the package substrate or lead frame of semiconductor package 301.

Moreover, in some implementations, composite control switch 320A may be monolithically integrated as disclosed by U.S. Patent Number 7,915,645, entitled "Monolithic Vertically Integrated Composite Group III-V and Group IV Semiconductor Device and Method for Fabricating Same", and issued on March 29, 2011; U.S. Patent Application Number 12/653,236, entitled "Monolithic Integrated Composite Group III-V and Group IV Semiconductor Device and Method for Fabricating Same", and filed on December 10, 2009; and U.S. Patent Application Number 12/928,103, entitled "Monolithic Integration of Silicon and Group III-V Devices", and filed on December 3, 2010. The aforementioned patent and patent applications are hereby incorporated fully by reference into the present application.

Continuing to Figure 3B, Figure 3B shows a plan view of integrated group III-V synchronous boost converter 300B including a composite power switch, according to another exemplary implementation. Boost converter 300B corresponds in general to boost converter 300A, in Figure 3A. However, according to the implementation shown in Figure 3B, power stage 325 includes composite sync switch 310B, while control switch 320 is implemented so as to correspond to control switch 120, in Figure 1, with which control switch 320 may share any of the characteristics attributed to that corresponding feature, above.

As shown in Figure 3B, composite sync switch 310B includes group III-V transistor 330 and group IV transistor 350. Group III-V transistor 330 may be a GaN or other III-Nitride based depletion mode HEMT. Group III-V transistor 330 includes source 332, drain 334, and gate 336. Group IV transistor 350 may be implemented as an LV group IV transistor, such as an LV silicon based MOSFET, for example. Group IV transistor 350 includes source 352, drain 354, and gate 356. Also shown in Figure 3B is body diode 358 of group IV transistor 350.

Group III-V transistor 330 is cascoded with group IV transistor 350 to produce composite sync switch 310B. That is to say, source 332 of group III-V transistor 330 is coupled to drain 354 of group IV transistor 350, source 352 of group IV transistor 350 provides a composite source for composite sync switch 310B, and gate 356 of group IV transistor 350 provides a composite gate for composite sync switch 310B. Moreover, drain 334 of group III-V transistor 330 provides a composite drain for composite sync switch 310B, while gate 336 of group III-V transistor 330 is coupled to source 352 of group IV transistor 350.

The operation of composite sync switch 310B as an enhancement mode switch through use of group IV transistor 350 is analogous to that previously described by reference to composite control switch 320A, in Figure 3A, and will not be further described here. Suffice it to say that composite sync switch 310B operates as an enhancement mode switch that can be selectively turned ON based on a gate voltage applied by driver stage 302 to gate 356 of group IV transistor 350.

In some implementations, composite sync switch 310B may adopt a cascoded configuration as disclosed by U.S. Patent Number 8,017,978, entitled "Hybrid Semiconductor Device", and issued on September 13, 2011; U.S. Patent Number 8,084,783, entitled "GaN-based Device Cascoded with an Integrated FET/Schottky Diode Device", and issued on December 27, 2011; U.S. Patent Application Number 13/415,779, entitled "Composite Semiconductor Device with Turn-On Prevention Control", and filed on March 8, 2012; U.S. Patent Application Number 13/416,252, entitled "High Voltage Composite Semiconductor Device with Protection for Low Voltage Device", and filed on March 9, 2012; and U.S. Patent Application Number 13/417,143, entitled "Composite Semiconductor Device with Active Oscillation Prevention", and filed on March 9, 2012. It is reiterated that the above-referenced patents and patent applications are incorporated fully by reference into the present application.

In some implementations, depletion mode group III-V transistor 330 and group IV transistor 350 of composite sync switch 310B may be fabricated in separate semiconductor dies (separate semiconductor dies not shown in Figure 3B). For example, group III-V transistor 330 may be fabricated in a group III-V die, which may include a group III-V active die formed over a group IV substrate, while group IV transistor 350 may be fabricated in a separate group IV die. In those implementations, it may be advantageous or desirable to mount the group III-V die providing group III-V transistor 330 on or over the group IV die providing group IV transistor 350. Examples of such die-stacking integration and mounting configurations are disclosed in U.S. Patent Application Number 13/433,864 entitled "Stacked Composite Device Including a Group III-V Transistor and a Group IV Lateral Transistor", filed on March 29, 2012; and U.S. Patent Application Number 13/434,412 entitled "Stacked Composite Device Including a Group III-V Transistor and a Group IV Vertical Transistor", also filed on March 29, 2012. It is reiterated that these patent applications are incorporated fully by reference into the present application.

Alternatively, in some other die-stacking integration implementations, it may be advantageous or desirable to mount the group IV die providing group IV transistor 350 on or over the group III-V die providing group III-V transistor 330. Examples of such die mounting configurations are disclosed in U.S. Patent Application Number 13/053,556, entitled "III-Nitride Transistor Stacked with FET in a Package", filed on March 22, 2011. It is reiterated that this patent application is incorporated fully by reference into the present application.

It is noted that in one implementation, group III-V transistor 330 may be integrated with control switch 320 on a common group III-V die separate from a group IV die used for fabrication of group IV transistor 350.

The die or dies used to implement power stage 325 may be mounted face up and wirebonded, ribbon bonded or Cu clipped, or may be flip-chip mounted to a package substrate or lead frame of semiconductor package 301. In some implementations, the die or dies used to implement power stage 325, including die 304 providing driver stage 302 may be configured so as to make electrical connection with one another through the package substrate or lead frame of semiconductor package 301.

Moreover, in some implementations, composite sync switch 310B may be monolithically integrated as disclosed by U.S. Patent Number 7,915,645, entitled "Monolithic Vertically Integrated Composite Group III-V and Group IV Semiconductor Device and Method for Fabricating Same", and issued on March 29, 2011; U.S. Patent Application Number 12/653,236, entitled "Monolithic Integrated Composite Group III-V and Group IV Semiconductor Device and Method for Fabricating Same", and filed on December 10, 2009; and U.S. Patent Application Number 12/928,103, entitled "Monolithic Integration of Silicon and Group III-V Devices", and filed on December 3, 2010. It is further reiterated that the aforementioned patent and patent applications are also incorporated fully by reference into the present application.

Moving to Figure 3C, Figure 3C shows a plan view of integrated group III-V synchronous boost converter 300C including two composite power switches, according to one exemplary implementation. Boost converter 300C corresponds in general to boost converters 300A and 300B, in respective Figures 3A and 3B. However, according to the implementation shown in Figure 3C, power stage 325 includes composite control switch 310A and composite sync switch 310B, each of which may be implemented as described above. It is noted that in some implementations, composite control switch 320A and composite sync switch 310B may be configured as a half-bridge, as disclosed by U.S. Patent Number 8,243,476, which has been cited and incorporated fully by reference into the present application, above. It is also noted that in some implementations, some of the components of boost converter 300C may be monolithically integrated, may be die-stacked integrated or may configured to include both forms of integration. For example, group III-V transistor 330 and group III-V transistor 340 may be formed on a common group III-V die. However, group IV transistor 350 and group IV transistor 360 may be discrete transistors formed on separate dies and be die-stacked integrated with group III-V transistor 330 and group III-V transistor 340, respectively. In certain implementations involving die-stacking and a common monolithic group III-V transistor die, one group IV transistor may be stacked under the common group III-V die, and the other group IV die may be stacked over the common group III-V die (three die-stacking integration). In yet another implementation, one of the group IV transistors may also be monolithically integrated with the common group III-V die while the other group IV transistor is die-stacked integrated with one of the group III-V transistors of the common group III-V die.

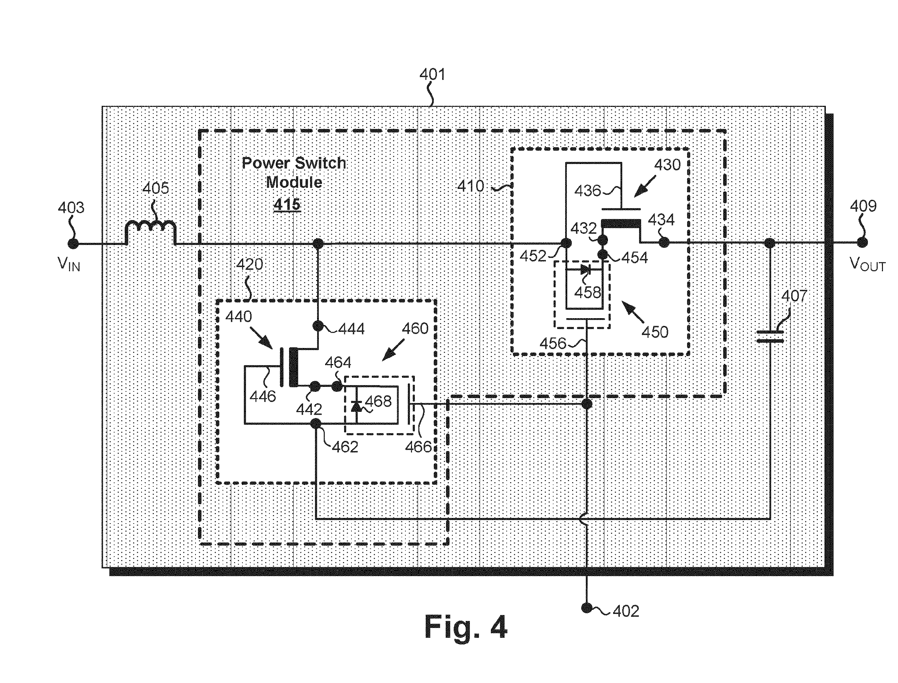

Referring now to Figure 4, Figure 4 shows a plan view of semiconductor package 401 including power switch module 415 for an integrated group III-V synchronous boost converter, according to one exemplary implementation. Power switch module 415 is situated in semiconductor package 401, and includes control switch 420 coupled to sync switch 410. As shown in Figure 4, one or both of control switch 420 and sync switch 410 may be implemented as respective composite switches. According to the implementation shown in Figure 4, control switch 420 includes group III-V transistor 440 having source 442, drain 444, and gate 446, and group IV transistor 460 having source 462, drain 464, gate 466, and body diode 468. In addition, sync switch 410 is shown to include group III-V transistor 430 having source 432, drain 434, and gate 436, and group IV transistor 450 having source 452, drain 454, gate 456, and body diode 458.

Semiconductor package 401 also includes input inductor 405 and output capacitor 407, both of which are shown to be coupled to control switch 420 and sync switch 410 of power switch module 415. As shown in Figure 4, power switch module 415 can receive an input voltage V_{IN} at input 403, and provide a converted voltage, e.g., a higher "stepped up" voltage V_{OUT}, at output 409. Also shown in Figure 4 is driver input 402 from one or more driver stages for driving respective control and sync switches 420 and 410.

Control and sync switches 420 and 410 correspond in general to respective control and sync switches 320/320A and 310/310B in Figures 3A, 3B and 3C. That is to say, control switch 420 including group III-V transistor 440 cascoded with group IV transistor 460 corresponds to composite control switch 320A including group III-V transistor 340 cascoded with group IV transistor 360, described by reference to Figures 3A and 3C. In addition, sync switch 410 including group III-V transistor 430 cascoded with group IV transistor 450 corresponds to composite sync switch 310B including group III-V transistor 330 cascoded with group IV transistor 350, described by reference to Figures 3B and 3C. Moreover, semiconductor package 401 corresponds in general to semiconductor package 101, in Figure 1, and may share any of the characteristics attributed to that corresponding feature, above.

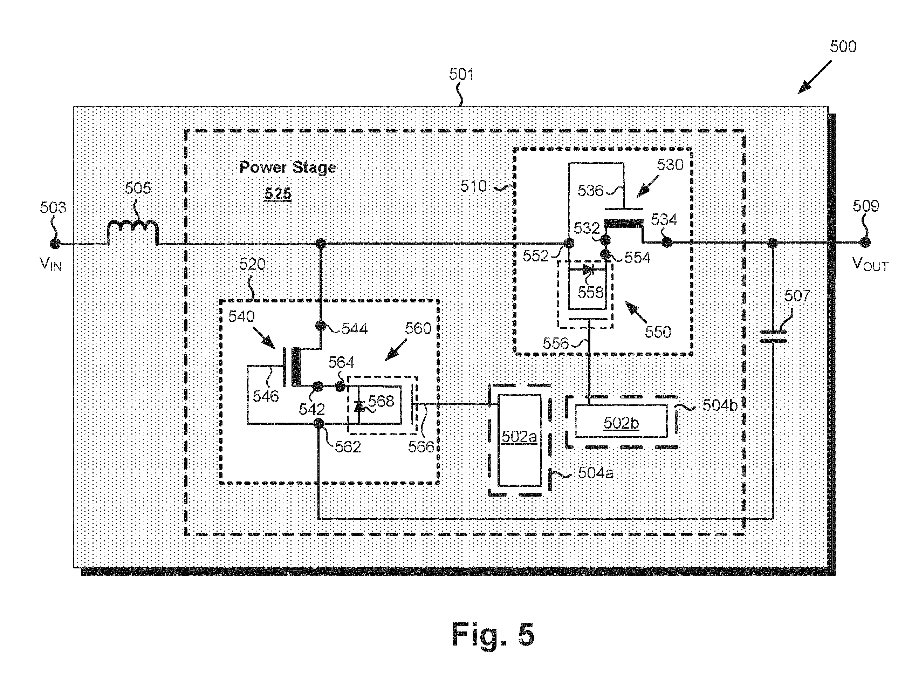

Continuing to Figure 5, Figure 5 shows a plan view of integrated group III-V synchronous boost converter 500, according to yet another exemplary implementation. Boost converter 500 includes power stage 525, which further includes driver stages 502a and 502b in respective dies 504a and 504b, and control switch 520 coupled to sync switch 510. As shown in Figure 5, one or both of control switch 520 and sync switch 510 may be implemented as respective composite switches. According to the implementation shown in Figure 5, control switch 520 includes group III-V transistor 540 having source 542, drain 544, and gate 546, and group IV transistor 560 having source 562, drain 564, gate 566, and body diode 568. In addition, sync switch 510 is shown to include group III-V transistor 530 having source 532, drain 534, and gate 536, and group IV transistor 550 having source 552, drain 554, gate 556, and body diode 558. Also shown in Figure 5 is semiconductor package 501.

Boost converter 500 also includes input inductor 505 and output capacitor 507, both of which are coupled to power stage 525. As shown in Figure 5, boost converter 500 can receive an input voltage V_{IN} at input 503 of boost converter 500, and provide a converted voltage, e.g., a higher "stepped up" voltage V_{OUT}, at output 509 of boost converter 500.

According to the exemplary implementation shown in Figure 5, control switch 520, sync switch 510, and one or both of dies 504a and 504b providing respective driver stages 502a and 502b may be situated in semiconductor package 501. Thus, according to the present exemplary implementation, semiconductor package 501 may take the form of an MCM. In addition, and as further shown by Figure 5, in some implementations, semiconductor package 501 may also include input inductor 505 and output capacitor 507.

Input inductor 505, output capacitor 507, and power stage 525 correspond respectively to input inductor 305, output capacitor 307, and power stage 325, in Figures 3A, 3B, and 3C, and may share any of the characteristics attributed to those corresponding features, above. Either or both of driver stages 502a and 502b fabricated in respective dies 504a and 504b may correspond to driver stage 102 in die 104, and may share any of the characteristics attributed to die 104, above. In other words, dies 504a and 504b may be implemented as silicon or other group IV dies, or as group III-V dies, such as III-Nitride dies. Thus, in some implementations, driver stages 502a and 502b may be implemented in respective group III-V dies 504a and 504b and may include group III-V circuitry, such as III-Nitride or other group III-V driver and/or predriver transistors.

However, unlike driver stage 102, which is configured to drive both control switch 120 and sync switch 110, driver stages 502a and 502b are each configured to drive a single power switch, i.e., respective control switch 520 and sync switch 510. It is noted that although Figure 5 depicts driver circuits 502a and 502b as being fabricated in separate respective dies 504a and 504b, in another implementation, driver circuits 502a and 502b can be integrated in a single semiconductor die corresponding to die 104, in Figure 1.

Semiconductor package 501 may be implemented utilizing a QFN package design, for example. Semiconductor package 501 may be a lead frame package, or may be formed using a laminate technology, as known in the art. Like boost converters 100, 200, and 300, shown by respective figures 1, 2, and 3A-3C, and like power switch module 415 in Figure 4, boost converter 500 depicted in Figure 5 includes several desirable features. For example, utilizing semiconductor package 101/201/301/401/501 having a substantially no-leads package design advantageously reduces parasitic inductances and capacitances of boost converter 100/200/300A/300B/300C/500. In addition, utilizaion of the various packaging layouts and integration techniques disclosed by the present application can further reduce parasitic inductances and capacitances while advantageously enabling reduction in package size. Moreover, by implementing driver circuitry and/or control and sync switches so as to include group III-V transistors, the present application discloses an integrated synchronous boost converter having reduced switching losses and thus capable of higher efficiency operation than conventional silicon based boost converter solutions.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A power stage comprising:
a control switch including a first group III-V transistor coupled to a sync switch including a second group III-V transistor;
a driver stage;
said driver stage, said control switch, and said sync switch of said power stage being situated in a single semiconductor package.

2. The power stage of claim 1, wherein said driver stage is configured to drive both said control switch and said sync switch.

3. The power stage of claim 1, wherein said driver stage is configured to drive one of said control switch and said sync switch, and another driver stage is configured to drive the other of said control switch and said sync switch.

4. The power stage of claim 1, wherein said control switch and said sync switch are integrated in a single semiconductor die.

5. The power stage of claim 1, wherein said driver stage is fabricated in a group III-V semiconductor die.

6. The power stage of claim 1, wherein said driver stage, said control switch, and said sync switch are integrated in a single semiconductor die.

7. The power stage of claim 1, wherein at least one of said first group III-V transistor and said second group III-V transistor is a depletion mode (normally ON) group III-V transistor.

8. The power stage of claim 1, wherein at least one of said first group III-V transistor and said second group III-V transistor is an enhancement mode (normally OFF) group III-V transistor.

9. The power stage of claim 1, wherein at least one of said control switch and said sync switch is a composite switch, said composite switch including a respective one of said first group III-V transistor and said second group III-V transistor cascoded with a low voltage (LV) group IV transistor.

10. The power stage of claim 1, wherein an input inductor and an output capacitor are situated in said single semiconductor package.

11. The power stage of claim 1, wherein said single semiconductor package comprises a quad-flat no-leads (QFN) package.

12. The power stage of claim 1, wherein at least one of said first group III-V transistor and said second group III-V transistor is a bi-directional dual gated group III-V transistor.

13. The power stage of claim 1, wherein said control switch and said sync switch are composite switches and wherein said first group III-V transistor and said second group III-V transistor are formed on a common die.

14. The power stage of claim 1, wherein at least one gate drive of said driver stage is integrated with at least one of said first group III-V transistor and said second group III-V transistor.

15. The power stage of claim 1, wherein at least one of said first group III-V transistor and said second group III-V transistor is formed over a group IV substrate.
